# EUROPEAN PATENT APPLICATION

(11) **EP 4 647 839 A2**
(43) Date of publication of application: **12.11.2025**
(21) Application number: 25205445.7
(22) Date of filing: 29.09.2025
(51) Int. Cl.: G03F 7/00

(54) **BROADBAND RADIATION SOURCE AND METHOD FOR GENERATING BROADBAND OUTPUT RADIATION**

(71) Applicant: ASML Netherlands B.V., 5500 AH Veldhoven (NL)
(72) Inventor: PONGERS, Willem, Richard, 5500 AH Veldhoven (NL); HUGERS, Ronald, Franciscus, Herman, 5500 AH Veldhoven (NL); NEVELS, Teun, Diane, Geer, 5500 AH Veldhoven (NL)
(74) Representative: ASML Netherlands B.V.

(57) **Abstract**

Disclosed is a method of controlling a broadband radiation source comprising at least an optical fiber configured to receive pump radiation and generate broadband output radiation. The method comprises obtaining ambient pressure data describing an ambient pressure in an environment of the broadband radiation source; controlling at least one parameter of the pump radiation in dependence of the ambient pressure data; and generating the broadband output radiation using the pump radiation to excite the optical fiber and/or a working medium confined therein.

## Description

### FIELD

The present invention relates to a broadband wavelength radiation source, and in particular such a broadband radiation source in relation to metrology applications in the manufacture of integrated circuits.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-k₁ lithography may be used to process features with dimensions smaller than the classical resolution limit of a lithographic apparatus. In such process, the resolution formula may be expressed as CD = k₁×λ/NA, where λ is the wavelength of radiation employed, NA is the numerical aperture of the projection optics in the lithographic apparatus, CD is the "critical dimension" (generally the smallest feature size printed, but in this case half-pitch) and k₁ is an empirical resolution factor. In general, the smaller k₁ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

Metrology tools are used in many aspects of the IC manufacturing process, for example as alignment tools for proper positioning of a substrate prior to an exposure, leveling tools to measure a surface topology of the substrate, for e.g., focus control and scatterometry based tools for inspecting/measuring the exposed and/or etched product in process control. In each case, a radiation source is required. For various reasons, including measurement robustness and accuracy, broadband or white light radiation sources are increasingly used for such metrology applications. Among other techniques for white light generation, hollow-core optical waveguides may be used to convert narrowband input radiation to broadband output radiation via nonlinear optical processes. Various different types of hollow-core optical waveguides, such as for example hollow-core photonic crystal fiber (PCF), have been developed to suit the need of generating broadband radiation. It would be desirable to improve on present devices for broadband radiation generation.

### SUMMARY

According to a first aspect of the invention, there is provided a method of controlling a broadband radiation source, the broadband radiation source comprising at least an optical fiber configured to receive pump radiation and generate broadband output radiation, the method comprising: obtaining ambient pressure data describing an ambient pressure in an environment of the broadband radiation source; controlling at least one parameter of the pump radiation in dependence of the ambient pressure data; and generating the broadband output radiation using the pump radiation to excite the optical fiber and/or a working medium confined therein.

According to a second aspect of the invention, there is provided a broadband radiation source comprising: a pump radiation source for generating pump radiation; an optical fiber configured to receive the pump radiation and generate broadband output radiation; and a control module operable to: obtain ambient pressure data describing an ambient pressure in an environment of the broadband radiation source; and control at least one parameter of the pump radiation in dependence of the ambient pressure data.

According to a third aspect of the invention, there is provided a method of controlling a pump radiation source, the pump radiation source being configured to generate pump radiation for pumping a broadband radiation source to generate broadband output radiation, the method comprising: obtaining ambient pressure data describing an ambient pressure in an environment of the pump radiation source; and controlling at least one parameter of the pump radiation in dependence of the ambient pressure data.

### BRIEF DESCRIPTION OF THE DRAWINGS

Embodiments of the invention will now be described, by way of example only, with reference to the accompanying schematic drawings, in which:
- Figure 1(a) depicts a schematic overview of a first type of lithographic apparatus;
- Figure 1(b) depicts a schematic overview of a second type of lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 depicts a schematic overview of a scatterometry apparatus used as a metrology device, which may comprise a radiation source according to embodiments of the invention;
- Figure 5 depicts a schematic overview of a level sensor apparatus which may comprise a radiation source according to embodiments of the invention;
- Figure 6 depicts a schematic overview of an alignment sensor apparatus which may comprise a radiation source according to embodiments of the invention;
- Figure 7 is a schematic cross sectional view of a hollow core optical fiber that may form part of a radiation source according to an embodiment in a transverse plane (i.e. perpendicular to an axis of the optical fiber);
- Figure 8 depicts a schematic representation of a radiation source for providing broadband output radiation;
- Figures 9(a) and 9(b) schematically depict the transverse cross-sections of examples of hollow core photonic crystal fiber (HC-PCF) designs;
- Figure 10 is a flowchart of a first method of controlling a radiation source in dependence of ambient pressure;
- Figure 11 is a flowchart of a second method of controlling a radiation source in dependence of ambient pressure;
- Figure 12 is a schematic representation of a radiation source according to an embodiment for providing broadband output radiation; and
- Figure 13 depicts a block diagram of a computer system for controlling a broadband radiation source.

### DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

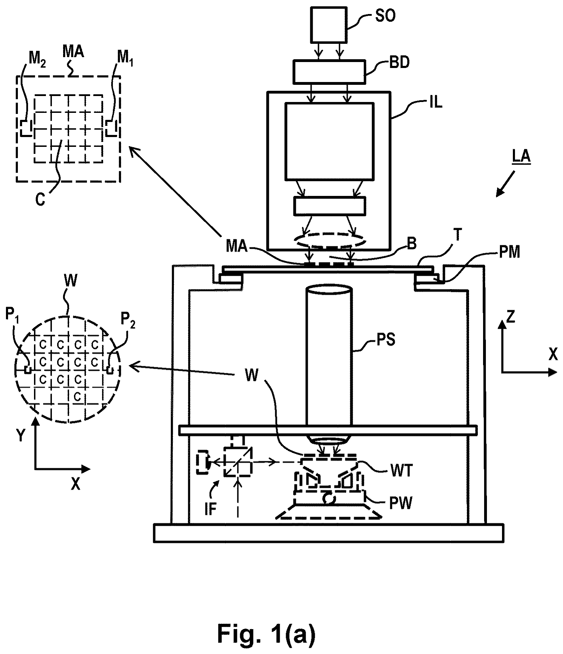

Figure 1(a) schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) T constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support T, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1(a)) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

To clarify the concepts disclosed herein, a Cartesian coordinate system is used. The Cartesian coordinate system has three axis, i.e., an x-axis, a y-axis and a z-axis. Each of the three axis is orthogonal to the other two axis. A rotation around the x-axis is referred to as an Rx-rotation. A rotation around the y-axis is referred to as an Ry-rotation. A rotation around about the z-axis is referred to as an Rz-rotation. The x-axis and the y-axis define a horizontal plane, whereas the z-axis is in a vertical direction. The Cartesian coordinate system is not limiting the invention and is used for clarification only. Instead, another coordinate system, such as a cylindrical coordinate system, may be used to clarify the invention. The orientation of the Cartesian coordinate system may be different, for example, such that the z-axis has a component along the horizontal plane.

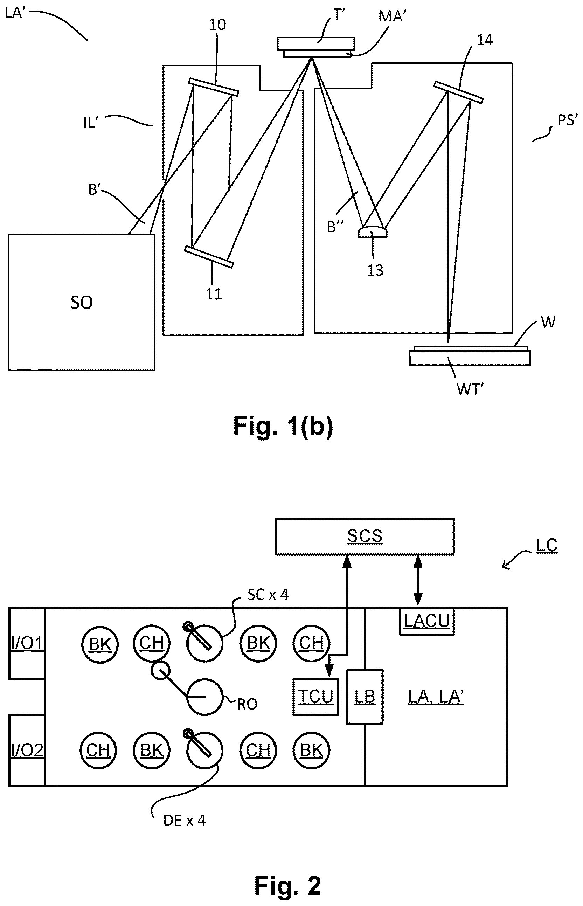

Figure 1(b) shows another lithographic system, comprising a radiation source SO' and a second example of a lithographic apparatus LA'. The radiation source SO' is configured to generate an EUV radiation beam B' and to supply the EUV radiation beam B' to the lithographic apparatus LA'. The lithographic apparatus LA' comprises an illumination system IL', a support structure MT' configured to support a patterning device MA' (e.g., a mask), a projection system PS' and a substrate table WT configured to support a substrate W.

The illumination system IL' is configured to condition the EUV radiation beam B' before the EUV radiation beam B' is incident upon the patterning device MA'. Thereto, the illumination system IL' may include a facetted field mirror device 10 and a facetted pupil mirror device 11. The faceted field mirror device 10 and faceted pupil mirror device 11 together provide the EUV radiation beam B' with a desired cross-sectional shape and a desired intensity distribution. The illumination system IL' may include other mirrors or devices in addition to, or instead of, the faceted field mirror device 10 and faceted pupil mirror device 11.

After being thus conditioned, the EUV radiation beam B' interacts with the patterning device MA'. As a result of this interaction, a patterned EUV radiation beam B'' is generated. The projection system PS' is configured to project the patterned EUV radiation beam B" onto the substrate W. For that purpose, the projection system PS' may comprise a plurality of mirrors 13,14 which are configured to project the patterned EUV radiation beam B" onto the substrate W held by the substrate table WT. The projection system PS' may apply a reduction factor to the patterned EUV radiation beam B", thus forming an image with features that are smaller than corresponding features on the patterning device MA'. For example, a reduction factor of 4 or 8 may be applied. Although the projection system PS' is illustrated as having only two mirrors 13,14 in Figure 1(b), the projection system PS' may include a different number of mirrors (e.g. six or eight mirrors).

The substrate W may include previously formed patterns. Where this is the case, the lithographic apparatus LA' aligns the image, formed by the patterned EUV radiation beam B", with a pattern previously formed on the substrate W.

A relative vacuum, i.e. a small amount of gas (e.g. hydrogen) at a pressure well below atmospheric pressure, may be provided in the radiation source SO, in the illumination system IL', and/or in the projection system PS'.

The radiation source SO' may be a laser produced plasma (LPP) source, a discharge produced plasma (DPP) source, a free electron laser (FEL) or any other radiation source that is capable of generating EUV radiation.

As shown in Figure 2 the lithographic apparatus LA or LA' of either of Figures 1(a) or 1(b) may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA, LA'. The devices in the lithocell, which are often also collectively referred to as the track, are typically under the control of a track control unit TCU that in itself may be controlled by a supervisory control system SCS, which may also control the lithographic apparatus LA, LA' e.g. via lithography control unit LACU.

In order for the substrates W exposed by the lithographic apparatus LA, LA' to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, LA', or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

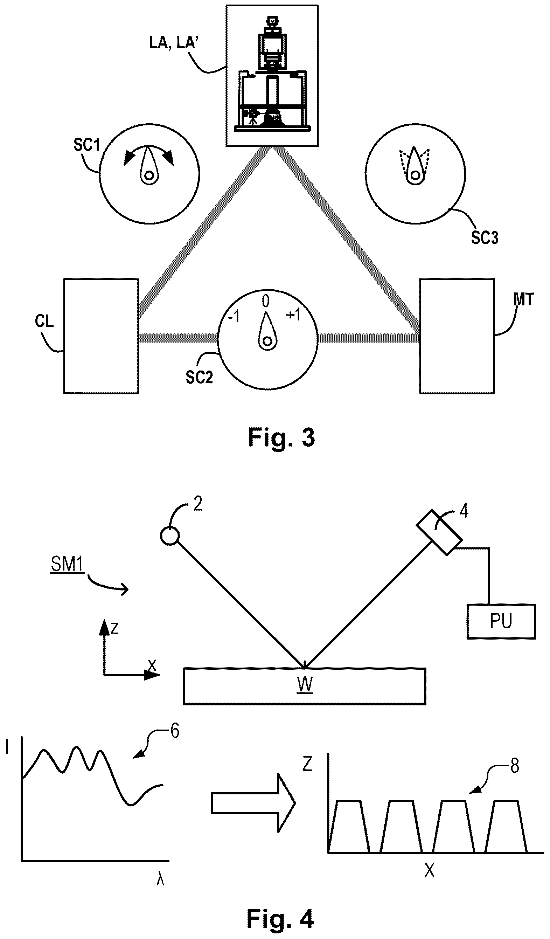

Typically the patterning process in a lithographic apparatus LA, LA' is one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA, LA' which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA, LA' stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). Typically, the resolution enhancement techniques are arranged to match the patterning possibilities of the lithographic apparatus LA, LA'. The computer system CL may also be used to detect where within the process window the lithographic apparatus LA is currently operating (e.g. using input from the metrology tool MT) to predict whether defects may be present due to e.g. sub-optimal processing (depicted in Fig. 3 by the arrow pointing "0" in the second scale SC2).

The metrology tool MT may provide input to the computer system CL to enable accurate simulations and predictions, and may provide feedback to the lithographic apparatus LA, LA' to identify possible drifts, e.g. in a calibration status of the lithographic apparatus LA, LA' (depicted in Fig. 3 by the multiple arrows in the third scale SC3).

In lithographic processes, it is desirable to make frequently measurements of the structures created, e.g., for process control and verification. Tools to make such measurement are typically called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from soft x-ray and visible to near-IR wavelength range.

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is an ellipsometric scatterometer. The ellipsometric scatterometer allows for determining parameters of a lithographic process by measuring scattered radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (typically overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for measuring overlay error between the two layers containing periodic structures as target is measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after etch process for example. Typically the pitch and line-width of the structures in the gratings strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resembles the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1incorporated herein by reference in its entirety.

A metrology apparatus, such as a scatterometer, is depicted in Figure 4. It comprises a broadband (white light) radiation projector 2 which projects radiation onto a substrate 6. The reflected or scattered radiation is passed to a spectrometer detector 4, which measures a spectrum 10 (i.e. a measurement of intensity as a function of wavelength) of the specular reflected radiation. From this data, the structure or profile giving rise to the detected spectrum may be reconstructed by processing unit PU, e.g. by Rigorous Coupled Wave Analysis and non-linear regression or by comparison with a library of simulated spectra as shown at the bottom of Figure 3. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

Overall measurement quality of a lithographic parameter via measurement of a metrology target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016/0161863 and published US patent application US 2016/0370717A1incorporated herein by reference in its entirety.

Another type of metrology tool used in IC manufacture is a topography measurement system, level sensor or height sensor. Such a tool may be integrated in the lithographic apparatus, for measuring a topography of a top surface of a substrate (or wafer). A map of the topography of the substrate, also referred to as height map, may be generated from these measurements indicating a height of the substrate as a function of the position on the substrate. This height map may subsequently be used to correct the position of the substrate during transfer of the pattern on the substrate, in order to provide an aerial image of the patterning device in a properly focus position on the substrate. It will be understood that "height" in this context refers to a dimension broadly out of the plane to the substrate (also referred to as Z-axis). Typically, the level or height sensor performs measurements at a fixed location (relative to its own optical system) and a relative movement between the substrate and the optical system of the level or height sensor results in height measurements at locations across the substrate.

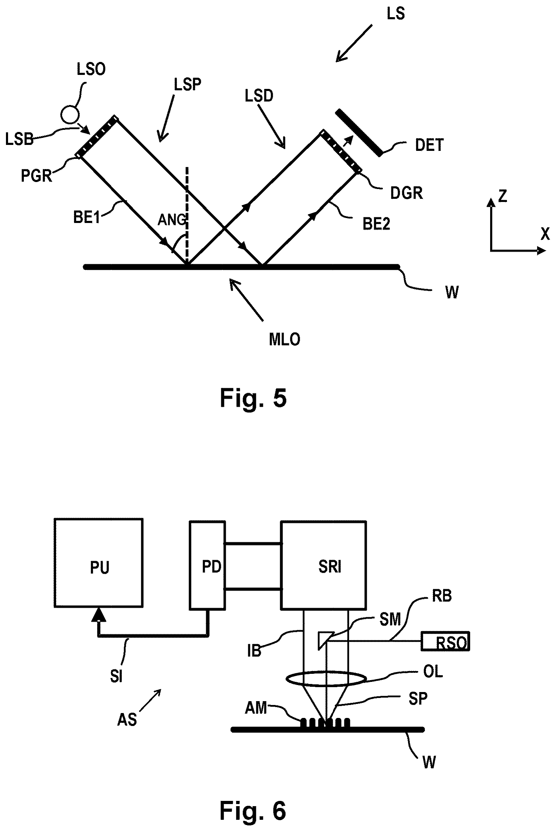

An example of a level or height sensor LS as known in the art is schematically shown in Figure 5, which illustrates only the principles of operation. In this example, the level sensor comprises an optical system, which includes a projection unit LSP and a detection unit LSD. The projection unit LSP comprises a radiation source LSO providing a beam of radiation LSB which is imparted by a projection grating PGR of the projection unit LSP. The radiation source LSO may be, for example, a narrowband or broadband light source, polarized or non-polarized, pulsed or continuous, such as a polarized or non-polarized laser beam. The radiation source LSO may include a plurality of radiation sources having different colors, or wavelength ranges, such as a plurality of LEDs. The radiation source LSO of the level sensor LS is not restricted to visible radiation, but may additionally or alternatively encompass UV and/or IR radiation and any range of wavelengths suitable to reflect from a surface of a substrate.

The projection grating PGR is a periodic grating comprising a periodic structure resulting in a beam of radiation BE1 having a periodically varying intensity. The beam of radiation BE1 with the periodically varying intensity is directed towards a measurement location MLO on a substrate W having an angle of incidence ANG with respect to an axis perpendicular (Z-axis) to the incident substrate surface between 0 degrees and 90 degrees, typically between 70 degrees and 80 degrees. At the measurement location MLO, the patterned beam of radiation BE1 is reflected by the substrate W (indicated by arrows BE2) and directed towards the detection unit LSD.

**In** order to determine the height level at the measurement location MLO, the level sensor further comprises a detection system comprising a detection grating DGR, a detector DET and a processing unit (not shown) for processing an output signal of the detector DET. The detection grating DGR may be identical to the projection grating PGR. The detector DET produces a detector output signal indicative of the light received, for example indicative of the intensity of the light received, such as a photodetector, or representative of a spatial distribution of the intensity received, such as a camera. The detector DET may comprise any combination of one or more detector types.

By means of triangulation techniques, the height level at the measurement location MLO can be determined. The detected height level is typically related to the signal strength as measured by the detector DET, the signal strength having a periodicity that depends, amongst others, on the design of the projection grating PGR and the (oblique) angle of incidence ANG.

The projection unit LSP and/or the detection unit LSD may include further optical elements, such as lenses and/or mirrors, along the path of the patterned beam of radiation between the projection grating PGR and the detection grating DGR (not shown).

In an embodiment, the detection grating DGR may be omitted, and the detector DET may be placed at the position where the detection grating DGR is located. Such a configuration provides a more direct detection of the image of the projection grating PGR.

In order to cover the surface of the substrate W effectively, a level sensor LS may be configured to project an array of measurement beams BE1 onto the surface of the substrate W, thereby generating an array of measurement areas MLO or spots covering a larger measurement range.

Various height sensors of a general type are disclosed for example in US7265364 and US7646471, both incorporated by reference. A height sensor using UV radiation instead of visible or infrared radiation is disclosed in US2010233600A1, incorporated by reference. In WO2016102127A1, incorporated by reference, a compact height sensor is described which uses a multi-element detector to detect and recognize the position of a grating image, without needing a detection grating.

Another type of metrology tool used in IC manufacture is an alignment sensor. A critical aspect of performance of the lithographic apparatus is therefore the ability to place the applied pattern correctly and accurately in relation to features laid down in previous layers (by the same apparatus or a different lithographic apparatus). For this purpose, the substrate is provided with one or more sets of marks or targets. Each mark is a structure whose position can be measured at a later time using a position sensor, typically an optical position sensor. The position sensor may be referred to as "alignment sensor" and marks may be referred to as "alignment marks".

A lithographic apparatus may include one or more (e.g. a plurality of) alignment sensors by which positions of alignment marks provided on a substrate can be measured accurately. Alignment (or position) sensors may use optical phenomena such as diffraction and interference to obtain position information from alignment marks formed on the substrate. An example of an alignment sensor used in current lithographic apparatus is based on a self-referencing interferometer as described in US6961116. Various enhancements and modifications of the position sensor have been developed, for example as disclosed in US2015261097A1. The contents of all of these publications are incorporated herein by reference.

Figure 6 is a schematic block diagram of an embodiment of a known alignment sensor AS, such as is described, for example, in US6961116, and which is incorporated by reference. Radiation source RSO provides a beam RB of radiation of one or more wavelengths, which is diverted by diverting optics onto a mark, such as mark AM located on substrate W, as an illumination spot SP. In this example the diverting optics comprises a spot mirror SM and an objective lens OL. The illumination spot SP, by which the mark AM is illuminated, may be slightly smaller in diameter than the width of the mark itself.

Radiation diffracted by the alignment mark AM is collimated (in this example via the objective lens OL) into an information-carrying beam IB. The term "diffracted" is intended to include zero-order diffraction from the mark (which may be referred to as reflection). A self-referencing interferometer SRI, e.g. of the type disclosed in US6961116 mentioned above, interferes the beam IB with itself after which the beam is received by a photodetector PD. Additional optics (not shown) may be included to provide separate beams in case more than one wavelength is created by the radiation source RSO. The photodetector may be a single element, or it may comprise a number of pixels, if desired. The photodetector may comprise a sensor array.

The diverting optics, which in this example comprises the spot mirror SM, may also serve to block zero order radiation reflected from the mark, so that the information-carrying beam IB comprises only higher order diffracted radiation from the mark AM (this is not essential to the measurement, but improves signal to noise ratios).

Intensity signals SI are supplied to a processing unit PU. By a combination of optical processing in the block SRI and computational processing in the unit PU, values for X- and Y-position on the substrate relative to a reference frame are output.

A single measurement of the type illustrated only fixes the position of the mark within a certain range corresponding to one pitch of the mark. Coarser measurement techniques are used in conjunction with this to identify which period of a sine wave is the one containing the marked position. The same process at coarser and/or finer levels may be repeated at different wavelengths for increased accuracy and/or for robust detection of the mark irrespective of the materials from which the mark is made, and materials on and/or below which the mark is provided. The wavelengths may be multiplexed and de-multiplexed optically so as to be processed simultaneously, and/or they may be multiplexed by time division or frequency division.

In this example, the alignment sensor and spot SP remain stationary, while it is the substrate W that moves. The alignment sensor can thus be mounted rigidly and accurately to a reference frame, while effectively scanning the mark AM in a direction opposite to the direction of movement of substrate W. The substrate W is controlled in this movement by its mounting on a substrate support and a substrate positioning system controlling the movement of the substrate support. A substrate support position sensor (e.g. an interferometer) measures the position of the substrate support (not shown). In an embodiment, one or more (alignment) marks are provided on the substrate support. A measurement of the position of the marks provided on the substrate support allows the position of the substrate support as determined by the position sensor to be calibrated (e.g. relative to a frame to which the alignment system is connected). A measurement of the position of the alignment marks provided on the substrate allows the position of the substrate relative to the substrate support to be determined.

Metrology tools MT, such as a scatterometer, topography measurement system, or position measurement system mentioned above may use radiation originating from a radiation source to perform a measurement. The properties of the radiation used by a metrology tool may affect the type and quality of measurements that may be performed. For some applications, it may be advantageous to use multiple radiation frequencies to measure a substrate, for example broadband radiation may be used. Multiple different frequencies may be able to propagate, irradiate, and scatter off a metrology target with no or minimal interference with other frequencies. Therefore different frequencies may for example be used to obtain more metrology data simultaneously. Different radiation frequencies may also be able to interrogate and discover different properties of a metrology target. Broadband radiation may be useful in metrology systems MT such as for example level sensors, alignment mark measurement systems, scatterometry tools, or inspection tools. A broadband radiation source may be a supercontinuum source.

High quality broadband radiation, for example supercontinuum radiation, may be difficult to generate. One method for generating broadband radiation may be to broaden high-power narrow band or single frequency input radiation, for example making use of non-linear, higher order effects. The input radiation (which may be produced using a laser) may be referred to as pump radiation. Alternatively, the input radiation may be referred to as seed radiation. To obtain high power radiation for broadening effects, radiation may be confined into a small area so that strongly localized high intensity radiation is achieved. In those areas, the radiation may interact with broadening structures and/or materials forming a non-linear medium so as to create broadband output radiation. In the high intensity radiation areas, different materials and/or structures may be used to enable and/or improve radiation broadening by providing a suitable non-linear medium.

In some implementations, the broadband output radiation is created in a photonic crystal fiber. (PCF). In several embodiments, such a photonic crystal fiber has microstructures around its fiber core assisting in confining radiation that travels through the fiber in the fiber core. The fiber core can be made of a solid material that has non-linear properties and that is capable of generating broadband radiation when high intensity pump radiation is transmitted through the fiber core. Although it is feasible to generate broadband radiation in solid core photonic crystal fibers, there may be a few disadvantages of using a solid material. For example, if UV radiation is generated in the solid core, this radiation might not be present in the output spectrum of the fiber because the radiation is absorbed by most solid material.

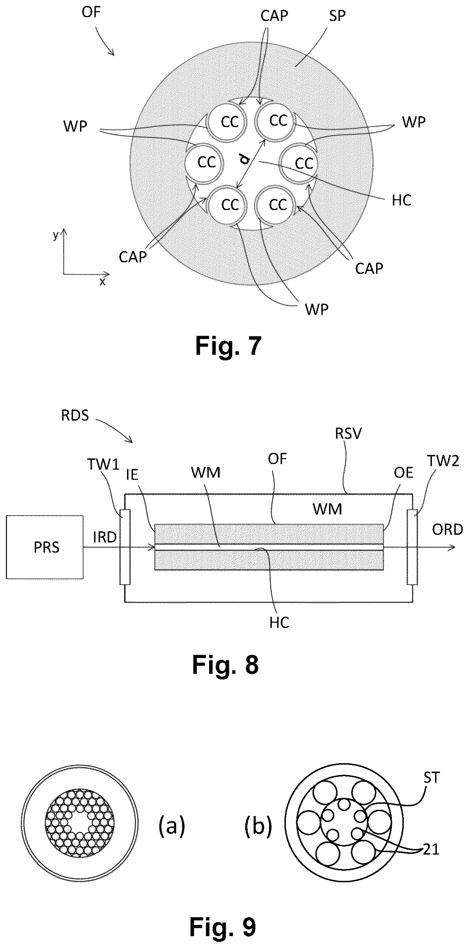

In some implementations, as discussed further below with reference to Figure 8, methods and apparatus for broadening input radiation may use a fiber for confining input radiation, and for broadening the input radiation to output broadband radiation. The fiber may be a hollow core fiber, and may comprise internal structures to achieve effective guiding and confinement of radiation in the fiber. The fiber may be a hollow core photonic crystal fiber (HC-PCF), which is particularly suitable for strong radiation confinement, predominantly inside the hollow core of the fiber, achieving high radiation intensities. The hollow core of the fiber may be filled with a gas acting as a broadening medium for broadening input radiation. Such a fiber and gas arrangement may be used to create a supercontinuum radiation source. Radiation input to the fiber may be electromagnetic radiation, for example radiation in one or more of the infrared, visible, UV, and extreme UV spectra. The output radiation may consist of or comprise broadband radiation, which may be referred to herein as white light. The output radiation may

Some embodiments relate to a new design of such a broadband radiation source comprising an optical fiber. The optical fiber is a hollow-core, photonic crystal fiber (HC-PCF). In particular, the optical fiber may be a hollow-core, photonic crystal fiber of a type comprising anti-resonant structures for confinement of radiation. Such fibers comprising anti-resonant structures are known in the art as anti-resonant fibers, tubular fibers, single-ring fibers, negative curvature fibers or inhibited coupling fibers. Various different designs of such fibers are known in the art. Alternatively, the optical fiber may be photonic bandgap fibers (HC-PBFs, for example a Kagome fiber).

A number of types of HC-PCFs can be engineered, each based on a different physical guidance mechanism. Two such HC-PCFs include: hollow-core photonic bandgap fibers (HC-PBFs) and hollow-core anti-resonant reflecting fibers (HC-ARFs). Detail on the design and manufacture of HC-PCFs can be found in US patent US2004/015085A1 (for HC-PBFs) and International PCT patent application WO2017/032454A1 (for Hollow Core anti-resonant reflecting fibers), which are incorporated herein by reference. Figure 9(a) shows a Kagome fiber, comprising a Kagome lattice structure.

An example of an optical fiber for use in the radiation source is now described with reference to Figure 7, which is a schematic cross sectional view of the optical fiber OF in a transverse plane. Further embodiments similar to the practical example of the fiber of Figure 7 are disclosed in WO2017/032454A1.

The optical fiber OF comprises an elongate body, which is longer in one dimension compared to the other two dimensions of the fiber OF. This longer dimension may be referred to as an axial direction and may define an axis of the optical fiber OF. The two other dimensions define a plane which may be referred to as a transverse plane. Figure 7 shows a cross-section of the optical fiber OF in this transverse plane (i.e. perpendicular to the axis), which is labelled as the x-y plane. The transverse cross-section of the optical fiber OF may be substantially constant along the fiber axis.

It will be appreciated that the optical fiber OF has some degree of flexibility and therefore the direction of the axis will not, in general, be uniform along the length of the optical fiber OF. The terms such as the optical axis, the transverse cross-section and the like will be understood to mean the local optical axis, the local transverse cross-section and so on. Furthermore, where components are described as being cylindrical or tubular these terms will be understood to encompass such shapes that may have been distorted as the optical fiber OF is flexed.

The optical fiber OF may have any length and it will be appreciated that the length of the optical fiber OF may be dependent on the application. The optical fiber OF may have a length between 1 cm and 10 m, for example, the optical fiber OF may have a length between 10 cm and 100 cm.

The optical fiber OF comprises: a hollow core COR; a cladding portion surrounding the hollow core COR; and a support portion SP surrounding and supporting the cladding portion. The optical fiber OF may be considered to comprise a body (comprising the cladding portion and the support portion SP) having a hollow core COR. The cladding portion comprises a plurality of anti-resonance elements for guiding radiation through the hollow core COR. In particular, the plurality of anti-resonance elements are arranged to confine radiation that propagates through the optical fiber OF predominantly inside the hollow core HC and to guide the radiation along the optical fiber OF. The hollow core HC of the optical fiber OF may be located substantially in a central region of the optical fiber OF, so that the axis of the optical fiber OF may also define an axis of the hollow core HC of the optical fiber OF.

The cladding portion comprises a plurality of anti-resonance elements for guiding radiation propagating through the optical fiber OF. In particular, in this embodiment, the cladding portion comprises a single ring of six tubular capillaries CAP. Each of the tubular capillaries CAP acts as an anti-resonance element.

The capillaries CAP may also be referred to as tubes. The capillaries CAP may be circular in cross section, or may have another shape. Each capillary CAP comprises a generally cylindrical wall portion WP that at least partially defines the hollow core HC of the optical fiber OF and separates the hollow core HC from a capillary cavity CC. It will be appreciated that the wall portion WP may act as an anti-reflecting Fabry-Perot resonator for radiation that propagates through the hollow core HC (and which may be incident on the wall portion WP at a grazing incidence angle). The thickness of the wall portion WP may be suitable so as to ensure that reflection back into the hollow core HC is generally enhanced whereas transmission into the capillary cavity CC is generally supressed. In some embodiments, the capillary wall portion WP may have a thickness between 0.01 - 10.0 µm.

It will be appreciated that, as used herein, the term cladding portion is intended to mean a portion of the optical fiber OF for guiding radiation propagating through the optical fiber OF (i.e. the capillaries CAP which confine said radiation within the hollow core COR). The radiation may be confined in the form of transverse modes, propagating along the fiber axis.

The support portion is generally tubular and supports the six capillaries CAP of the cladding portion. The six capillaries CAP are distributed evenly around an inner surface if the inner support portion SP. The six capillaries CAP may be described as being arranged in a generally hexagonal formation.

The capillaries CAP are arranged so that each capillary is not in contact with any of the other capillaries CAP. Each of the capillaries CAP is in contact with the inner support portion SP and spaced apart from adjacent capillaries CAP in the ring structure. Such an arrangement may be beneficial since it may increase a transmission bandwidth of the optical fiber OF (relative, for example, to an arrangement wherein the capillaries are in contact with each other). Alternatively, in some embodiments, each of the capillaries CAP may be in contact with adjacent capillaries CAP in the ring structure.

The six capillaries CAP of the cladding portion are arranged in a ring structure around the hollow core COR. An inner surface of the ring structure of capillaries CAP at least partially defines the hollow core HC of the optical fiber OF. The diameter d of the hollow core HC (which may be defined as the smallest dimension between opposed capillaries, indicated by arrow d) may be between 10 and 1000 µm. The diameter d of the hollow core HC may affect the mode field diameter, impact loss, dispersion, modal plurality, and non-linearity properties of the hollow core optical fiber OF.

In this embodiment, the cladding portion comprises a single ring arrangement of capillaries CAP (which act as anti-resonance elements). Therefore, a line in any radial direction from a center of the hollow core HC to an exterior of the optical fiber OF passes through no more than one capillary CAP.

It will be appreciated that other embodiments may be provided with different arrangements of anti-resonance elements. These may include arrangements having multiple rings of anti-resonance elements and arrangements having nested anti-resonance elements. Furthermore, although the embodiment shown in Figure 7 comprises a ring of six capillaries, in other embodiments, one or more rings comprising any number of anti-resonance elements (for example 4, 5, 6, 7, 8, 9, 10, 11 or 12 capillaries) may be provided in the cladding portion.

Figure 9(b) shows a modified embodiment of the above discussed HC-PCFs with a single ring of tubular capillaries. In the example of Figure 9(b) there are two coaxial rings of tubular capillaries 21. For holding the inner and outer rings of tubular capillaries 21, a support tube ST may be included in the HC-PCF. The support tube may be made of silica.

The tubular capillaries of the examples of Figure 7 and Figures 9 (a) and (b) may have a circular cross-sectional shape. Other shapes are also possible for the tubular capillaries, like elliptical or polygonal cross-sections. Additionally, the solid material of the tubular capillaries of the examples of Figure 7 and Figures 9 (a) and (b) may comprise plastic material, like PMA, glass, like silica, or soft glass.

Figure 8 depicts a radiation source RDS for providing broadband output radiation. The radiation source RDS comprises a pulsed pump radiation source PRS or any other type of source that is capable of generating short pulses of a desired length and energy level; an optical fiber OF (for example of the type shown in Figure 7) with a hollow core COR; and a working medium WM (for example a gas) confined within the hollow core COR. Although in Figure 8 the radiation source RDS comprises the optical fiber OF shown in Figure 7, in alternative embodiments other types of hollow core optical fiber may be used.

The pulsed pump radiation source PRS is configured to provide input radiation IRD. The hollow core HC of the optical fiber OF is arranged to receive the input radiation IRD from the pulsed pump radiation source PRS, and broaden it to provide output radiation ORD. The working medium WM enables the broadening of the frequency range of the received input radiation IRD so as to provide broadband output radiation ORD.

The radiation source RDS further comprises a reservoir RSV. The optical fiber OF is located inside the reservoir RSV. The reservoir RSV may also be referred to as a housing, container or gas cell. The reservoir RSV is configured to contain the working medium WM. The reservoir RSV may comprise one or more features, known in the art, for controlling, regulating, and/or monitoring the composition of the working medium WM (which may be a gas) inside the reservoir RSV. The reservoir RSV may comprise a first transparent window TW1. In use, the optical fiber OF is located inside the reservoir RSV such that the first transparent window TW1 is located proximate to an input end IE of the optical fiber OF. The first transparent window TW1 may form part of a wall of the reservoir RSV. The first transparent window TW1 may be transparent for at least the received input radiation frequencies, so that received input radiation IRD (or at least a large portion thereof) may be coupled into the optical fiber OF located inside reservoir RSV. It will be appreciated that optics (not shown) may be provided for coupling the input radiation IRD into the optical fiber OF.

The reservoir RSV comprises a second transparent window TW2, forming part of a wall of the reservoir RSV. In use, when the optical fiber OF is located inside the reservoir RSV, the second transparent window TW2 is located proximate to an output end OE of the optical fiber OF. The second transparent window TW2 may be transparent for at least the frequencies of the broadband output radiation ORD of the radiation source RDS.

Alternatively, in another embodiment, the two opposed ends of the optical fiber OF may be placed inside different reservoirs. The optical fiber OF may comprise a first end section configured to receive input radiation IRD, and a second end section for outputting broadband output radiation ORD. The first end section may be placed inside a first reservoir, comprising a working medium WM. The second end section may be placed inside a second reservoir, wherein the second reservoir may also comprise a working medium WM. The functioning of the reservoirs may be as described in relation to Figure 8 above. The first reservoir may comprise a first transparent window, configured to be transparent for input radiation IRD. The second reservoir may comprise a second transparent window configured to be transparent for broadband output broadband radiation ORD. The first and second reservoirs may also comprise a sealable opening to permit the optical fiber OF to be placed partially inside and partially outside the reservoir, so that a gas can be sealed inside the reservoir. The optical fiber OF may further comprise a middle section not contained inside a reservoir. Such an arrangement using two separate gas reservoirs may be particularly convenient for embodiments wherein the optical fiber OF is relatively long (for example when the length is more than 1 m). It will be appreciated that for such arrangements which use two separate gas reservoirs, the two reservoirs (which may comprise one or more features, known in the art, for controlling, regulating, and/or monitoring the composition of a gas inside the two reservoirs) may be considered to provide an apparatus for providing the working medium WM within the hollow core HC of the optical fiber OF.

In this context a window may be transparent for a frequency if at least 50%, 75%, 85%, 90%, 95%, or 99% of incident radiation of that frequency on the window is transmitted through the window.

Both the first TW1 and the second TW2 transparent windows may form an airtight seal within the walls of the reservoir RSV so that the working medium WM (which may be a gas) may be contained within the reservoir RSV. It will be appreciated that the gas WM may be contained within the reservoir RSV at a pressure different to the ambient pressure of the reservoir RSV.

The working medium WM may comprise a noble gas such as Argon, Krypton, and Xenon, a Raman active gas such as Hydrogen, Deuterium and Nitrogen, or a gas mixture such as an Argon/Hydrogen mixture, a Xenon/Deuterium mixture, a Krypton/Nitrogen mixture, or a Nitrogen/Hydrogen mixture. Depending on the type of filling gas, the nonlinear optical processes can include modulation instability (MI), soliton self-compression, soliton fission, Kerr effect, Raman effect and dispersive wave generation, details of which are described in WO2018/127266A1 and US9160137B1 (both of which are hereby incorporated by reference). Since the dispersion of the filling gas can be tuned by varying the working medium WM pressure in the reservoir RSR (i.e. gas cell pressure), the generated broadband pulse dynamics and the associated spectral broadening characteristics can be adjusted so as to optimize the frequency conversion

In one implementation, the working medium WM may be confined within the hollow core HC at least during receipt of input radiation IRD for producing broadband output radiation ORD. It will be appreciated that, while the optical fiber OF is not receiving input radiation IRD for producing broadband output radiation, the gas WM may be wholly or partially absent from the hollow core COR.

In order to achieve frequency broadening high intensity radiation may be desirable. An advantage of having a hollow core optical fiber OF is that it may achieve high intensity radiation through strong spatial confinement of radiation propagating through the optical fiber OF, achieving high localised radiation intensities. The radiation intensity inside the optical fiber OF may be high, for example due to high received input radiation intensity and/or due to strong spatial confinement of the radiation inside the optical fiber OF. An advantage of hollow core optical fibers is that they can guide radiation having a broader wavelength range that solid-core fibers and, in particular, hollow core optical fibers can guide radiation in both the ultraviolet and infrared ranges.

An advantage of using a hollow core optical fiber OF may be that the majority of the radiation guided inside the optical fiber OF is confined to the hollow core COR. Therefore, the majority of the interaction of the radiation inside the optical fiber OF is with the working medium WM, which is provided inside the hollow core HC of the optical fiber OF. As a result, the broadening effects of the working medium WM on the radiation may be increased.

The received input radiation IRD may be electromagnetic radiation. The input radiation IRD may be received as pulsed radiation. For example, the input radiation IRD may comprise ultrafast pulses, for example, generated by a laser.

The input radiation IRD may be coherent radiation. The input radiation IRD may be collimated radiation, an advantage of which may be to facilitate and improve the efficiency of coupling the input radiation IRD into the optical fiber OF. The input radiation IRD may comprise a single frequency, or a narrow range of frequencies. The input radiation IRD may be generated by a laser. Similarly, the output radiation ORD may be collimated and/or may be coherent.

The input radiation IRD provided by the pulsed pump radiation source PRS may be pulsed. The input radiation IRD may comprise electromagnetic radiation of one or more frequencies between 200 nm and 2 µm. The input radiation IRD may for example comprise electromagnetic radiation with a wavelength of 1.03 µm. The repetition rate of the pulsed radiation IRD may be of an order of magnitude of 1 kHz to 100 MHz. The pulse energies may have an order of magnitude of 1 nJ to 100 µJ, for example 1 - 10 µJ. A pulse duration for the input radiation IRD may be between 1 fs and 10 ns, for example 400 fs. The average power of input radiation IRD may be between 1 mW to several 100 W. The average power of input radiation IRD may for example be 20 - 50 W.

The broadband range of the output radiation ORD may be a continuous range, comprising a continuous range of radiation frequencies. The output radiation ORD may comprise supercontinuum radiation. Continuous radiation may be beneficial for use in a number of applications, for example in metrology applications. For example, the continuous range of frequencies may be used to interrogate a large number of properties. The continuous range of frequencies may for example be used to determine and/or eliminate a frequency dependency of a measured property. Supercontinuum output radiation ORD may comprise for example electromagnetic radiation over a wavelength range of 100 nm - 4000 nm. The broadband output radiation ORD frequency range may be for example 400 nm - 900 nm, 500 nm - 900 nm, or 200 nm - 2000 nm. The supercontinuum output radiation ORD may comprise white light.

The pulsed pump radiation source PRS may be a laser. The spatio-temporal transmission characteristics of such a laser pulse, e.g. its spectral amplitude and phase, transmitted along the optical fiber OF can be varied and tuned through adjustment of (pump) laser parameters, working component WM variations, and optical fiber OF parameters. Said spatio-temporal transmission characteristics may include one or more of: output power, output mode profile, output temporal profile, width of the output temporal profile (or output pulse width), output spectral profile, and bandwidth of the output spectral profile (or output spectral bandwidth). Said pulse pump radiation source PRS parameters may include one or more of: pump wavelength, pump pulse energy, pump pulse width, pump pulse repetition rate. Said optical fiber OF parameters may include one or more of: optical fiber length, size and shape of the hollow core 101, size and shape of the capillaries, thickness of the walls of the capillaries surrounding the hollow core. Said working component WM, e.g. filling gas, parameters may include one or more of: gas type, gas pressure and gas temperature.

The broadband output radiation ORD provided by the radiation source RDS may have an average output power of at least 1 W. The average output power may be at least 5 W. The average output power may be at least 10 W. The broadband output radiation ORD may be pulsed broadband output radiation ORD. The broadband output radiation ORD may have a power spectral density in the entire wavelength band of the output radiation of at least 0.01 mW/nm. The power spectral density in the entire wavelength band of the broadband output radiation may be at least 3 mW/nm.

The pulsed pump radiation typically has a narrow pulse width, which creates high peak powers. By careful selection of the fiber dimensions (e.g., core size, capillary thickness, fiber length) and working medium parameters (e.g., gas mixture/species, gas partial pressures), as has been described, a supercontinuum is formed via a non-linear optical process (e.g., Modulational Instability or any of the other processes described above).

It is known that the pulse shape and pulse duration of the pump radiation source will affect the supercontinuum generation process. This has been shown both by simulations and experimentally. For example, it can be demonstrated that the amount of generated white output radiation (e.g., in the range 425 - 860 nm) is inversely proportional to the pump pulse duration.

However, the inventors have determined that characteristics of the generated output radiation are also dependent on the ambient pressure. The inventors speculate that the ambient pressure affects the pump pulse width, possibly as a result of dispersion effects; e.g., pressure variation causes the refractive index along the pulse path to vary, which in turn affects pulse length. Regardless of the actual mechanism, the effect of ambient pressure on the output radiation has been demonstrated.

As such, it is proposed herein to control at least one parameter of the pump radiation (input radiation) in dependence of ambient pressure, when generating broadband radiation within an optical fiber. The optical fiber may comprise a hollow core fiber such as a HC-PCF having a working medium (e.g., a gas, more specifically a gas under pressure) confined within its core. The working medium and the hollow core fiber may be sealed within a gas cell, such that the core of the hollow core fiber is in communication with (and therefore confined within) the working fluid sealed in the gas cell.

The at least one parameter of the pump radiation may comprise a power and/or energy metric (e.g., the peak power and/or peak energy) of the pump radiation (i.e., the pump pulse). This may be achieved for example by controlling a modulator or attenuator which modulates or attenuates the pump source output. A suitable modulator may comprise an acousto-optical modulator (AOM) or electro-optic modulator (EOM), and a suitable attenuator may comprise a laser power attenuator, e.g., such as a half-wave plate and polarizer. Alternatively, this may be achieved by control of the pump source itself.

Alternatively or in addition, the at least one parameter of the pump radiation may comprise a pulse shape metric (e.g., the pulse width and/or chirp) of the pump radiation. A change in chirp (i.e., frequency over time) results in a change of shape of the pulse envelope (e.g., 2nd order chirp results in a different shape than 3rd order chirp). More specifically, a second order chirp results in a symmetrical widening or broadening of the pump pulse compared to no chirp, while a third order chirp results in an asymmetrical pulse shape change of the pump pulse compared to no chirp (e.g., where the unchirped pump pulse is symmetrical, a third order chirp will result in an asymmetrical pulse shape). The chirp can be controlled within the pump source. Alternatively, the chirp may be controlled by a modulator (e.g., AOM or EOM), or grating-based compressor e.g. a piezo-actuated grating within such a compressor.

The method may comprise measuring the ambient temperature, e.g., using any suitable pressure sensor suitable for measuring ambient pressure. The pressure sensor may be located within the vicinity of the pump radiation source, e.g., within or close to a pump radiation source module. However, this is not strictly required, and the pressure sensor may be located within the same room, within the same facility or even within the same geographic area/town. Alternatively, instead of using a sensor to measure pressure, the ambient pressure data may be sourced from elsewhere, e.g., from (e.g., commercial) meteorology (weather) data.

If a pressure sensor is used, the measured ambient pressure data may optionally be filtered (i.e., low-pass filtered) prior to using it for control of the at least one parameter of the pump radiation. As such a low-pass filter may be provided (e.g., in software within a control module or otherwise) to perform the low-pass filtering. This can be used to remove noise from the ambient pressure data, e.g., such that the data is representative of being on a scale on the order of a minute, tens of minutes or an hour. Alternatively, or in addition, the averaged measured ambient pressure data may be used, e.g., averaged over a timescale on the order of a minute, tens of minutes or an hour. For example, the ambient pressure value used for control at a certain time may comprise an average of the readings over the last minute or hour (or time period on a similar scale).

The method may comprise an initial calibration step to calibrate the relationship between the measured pressure (e.g., a change in pressure) and the at least one parameter of the pump radiation, such that the at least one parameter of the pump radiation is properly adjusted in dependence of the pressure to achieve a desired the radiation source output (i.e., the broadband output from the optical fiber).

For example, the desired broadband output radiation characteristic may comprise a stable output, with desired spectral characteristics, for an ambient pressure range as might be typically encountered in normal atmospheric variation (e.g., for a given location). This relationship may differ from system to system and need calibration per system. Alternatively, this relationship may require only a single calibration for all systems. For example, the radiation source output (i.e., the broadband output from the optical fiber) may be measured with varying pressure, and for each pressure value, or each pressure difference with respect to a reference ambient pressure value, the change in a value of the at least one parameter of the pump radiation (e.g., a pump radiation correction) may be determined to achieve (e.g., maintain) the desired broadband output radiation characteristic. This may be achieved by measuring the output with change of the at least one parameter of the pump radiation over a period of time when the atmospheric pressure changes, or with the system or at least the pump source within an environment where the ambient pressure can be controlled.

Once calibrated, pairs of ambient pressure change and the corresponding pump radiation correction may be saved as calibration data (e.g., a look-up table), or a relationship between the two may be fitted and used to determine the pump radiation correction in dependence of a pressure change. In another example, a machine learning model may be trained to map the ambient pressure change to a corresponding pump radiation correction.

An alternative approach, or complementary monitor, may comprise monitoring the radiation source output in use, and employing a feedback approach to determine the appropriate pump radiation correction in dependence of a pressure change, e.g., to maintain a desired broadband output radiation characteristic the at least one pump radiation parameter may be varied (e.g., over a predetermined range) till the desired broadband output radiation characteristic is measured. The appropriate correction can also be learnt over time, e.g., by storing pairs of pressure change and pump radiation correction values as calibration data e.g., in the form of a look-up table, learning a relationship between these two parameters, or training a machine learning model to map between the two parameters. Some aspects of the basic relationship may already be known, such as the direction of the correction with respect to the direction in the change of pressure. For example, an increase in ambient pressure may mean that the pulse energy is increased and *vice versa.*

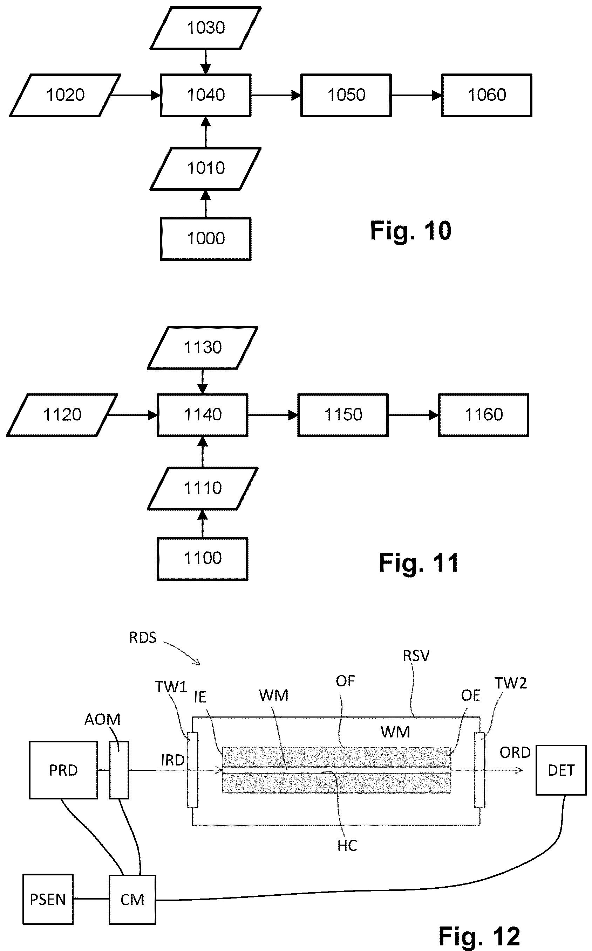

Figure 10 is a flowchart of a first example of the method proposed herein. The ambient pressure may be measured 1000, e.g., using a suitable pressure sensor, to obtain ambient pressure data 1010. The ambient pressure data 1000 may be compared to a reference pressure 1020 (e.g., a nominal ambient pressure) and a correction determined 1040 for a modulator (e.g., an AOM) based on this comparison. Instead of a modulator, an attenuator may be used. For example, the correction may be determined based on previously determined calibration data or calibration model 1030 resulting from a calibration performed as described. At step 1050, the correction is applied to the pump radiation via the modulator (or attenuator). The modulated or attenuated pump radiation is then used to generate 1060 broadband radiation by exciting a working medium within an optical fiber (e.g., a HC-PCF).

Figure 11 is a flowchart of a second example of the method proposed herein. The ambient pressure may be measured 1100, e.g., using a suitable pressure sensor, to obtain ambient pressure data 1110. The ambient pressure data 1100 may be compared to a reference pressure 1120 (e.g., a nominal ambient pressure) and a correction determined 1140 for the pump radiation source based on this comparison. For example, the correction may be determined based on previously determined calibration data or calibration model 1130 resulting from a calibration performed as described. In a specific example, the correction may vary a chirp of the pulse of the pump radiation emitted by the pump radiation source. At step 1150, the correction is applied via the pump radiation source (or via a modulator modulating the output of the pump radiation source). The resultant pump radiation is then used to generate 1160 broadband radiation by exciting a working medium within an optical fiber (e.g., a HC-PCF).

Figure 12 is a schematic illustration of a source apparatus according to examples disclosed herein. Many of the elements of this source apparatus are the same as that already described in relation to Figure 8 and therefore will not be described again. Optionally, a modulator AOM (e.g., an acoustooptic modulator) or attenuator may be provided to modulate the pump radiation source PRD output. A pressure sensor PSEN measures the ambient pressure and sends pressure data to a control module CM (e.g., comprising one or more processors). The control module CM, in dependence of the ambient pressure and optionally a reference pressure which may be stored within the control module or elsewhere, determines a correction for one or both of the modulator AOM (e.g., to perform the method of Figure 10) or the pump radiation source PRD (e.g., to perform the method of Figure 11). In the latter case, the modulator AOM may be dispensed with (although control of the pulse power/energy using a modulator may be useful more generally). Optionally, an output detector DET may provided to measure one or more of the output radiation ORD (e.g., its spectral composition). Based on the measured output radiation, the controller may determine an appropriate correction for a measured change in pressure and/or may monitor the output radiation ORD. Alternatively or in addition a detector (not shown) may be provided to measure the input radiation IRD (e.g., between the modulator AOM and optical fiber OF) and provide a feedback signal to the control module CM.

"Broadband", in the context of the broadband output radiation, may comprise radiation comprising wavelengths spanning a range greater than 40nm, greater than 50nm, greater than greater than 70nm, greater than 100nm, greater than 150nm or greater than 200nm, for example. The broadband output radiation may comprise a supercontinuum (e.g., comprising energy at all wavelengths spanning a range of interest) or otherwise (e.g., where there may be gaps between some wavelengths of the range of interest, such as a comb profile).

The broadband output radiation may be used for any metrology application, e.g., it may be used as measurement radiation for any of the apparatuses of Figures 4, 5 and/or 6.

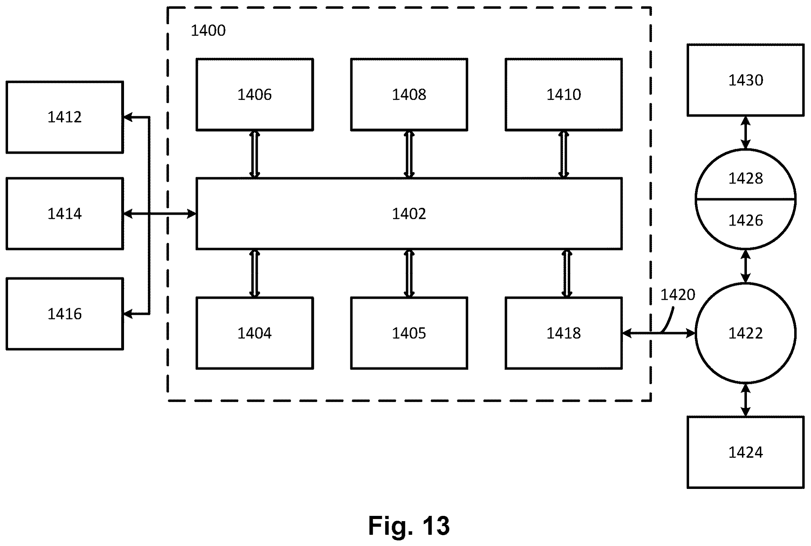

Figure 13 is a block diagram that illustrates a computer system 1400 that may assist in implementing the methods and flows disclosed herein. The control module CM of Figure 12 may comprise such a computer system 1400 (or elements thereof), for example. Computer system 1400 includes a bus 1402 or other communication mechanism for communicating information, and a processor 1404 (or multiple processors 1404 and 1405) coupled with bus 1402 for processing information. Computer system 1400 also includes a main memory 1406, such as a random access memory (RAM) or other dynamic storage device, coupled to bus 1402 for storing information and instructions to be executed by processor 1404. Main memory 1406 also may be used for storing temporary variables or other intermediate information during execution of instructions to be executed by processor 1404. Computer system 1400 further includes a read only memory (ROM) 1408 or other static storage device coupled to bus 1402 for storing static information and instructions for processor 1404. A storage device 1410, such as a magnetic disk or optical disk, is provided and coupled to bus 1402 for storing information and instructions.

Computer system 1400 may be coupled via bus 1402 to a display 1412, such as a cathode ray tube (CRT) or flat panel or touch panel display for displaying information to a computer user. An input device 1414, including alphanumeric and other keys, is coupled to bus 1402 for communicating information and command selections to processor 1404. Another type of user input device is cursor control 1416, such as a mouse, a trackball, or cursor direction keys for communicating direction information and command selections to processor 1404 and for controlling cursor movement on display 1412. This input device typically has two degrees of freedom in two axes, a first axis (e.g., x) and a second axis (e.g., y), that allows the device to specify positions in a plane. A touch panel (screen) display may also be used as an input device.

One or more of the methods as described herein may be performed by computer system 1400 in response to processor 1404 executing one or more sequences of one or more instructions contained in main memory 1406. Such instructions may be read into main memory 1406 from another computer-readable medium, such as storage device 1410. Execution of the sequences of instructions contained in main memory 1406 causes processor 1404 to perform the process steps described herein. One or more processors in a multi-processing arrangement may also be employed to execute the sequences of instructions contained in main memory 1406. In an alternative embodiment, hard-wired circuitry may be used in place of or in combination with software instructions. Thus, the description herein is not limited to any specific combination of hardware circuitry and software.

The term "computer-readable medium" as used herein refers to any medium that participates in providing instructions to processor 1404 for execution. Such a medium may take many forms, including but not limited to, non-volatile media, volatile media, and transmission media. Non-volatile media include, for example, optical or magnetic disks, such as storage device 1410. Volatile media include dynamic memory, such as main memory 1406. Transmission media include coaxial cables, copper wire and fiber optics, including the wires that comprise bus 1402. Transmission media can also take the form of acoustic or light waves, such as those generated during radio frequency (RF) and infrared (IR) data communications. Common forms of computer-readable media include, for example, a floppy disk, a flexible disk, hard disk, magnetic tape, any other magnetic medium, a CD-ROM, DVD, any other optical medium, punch cards, paper tape, any other physical medium with patterns of holes, a RAM, a PROM, and EPROM, a FLASH-EPROM, any other memory chip or cartridge, a carrier wave as described hereinafter, or any other medium from which a computer can read.

Various forms of computer readable media may be involved in carrying one or more sequences of one or more instructions to processor 1404 for execution. For example, the instructions may initially be borne on a magnetic disk of a remote computer. The remote computer can load the instructions into its dynamic memory and send the instructions over a telephone line using a modem. A modem local to computer system 1400 can receive the data on the telephone line and use an infrared transmitter to convert the data to an infrared signal. An infrared detector coupled to bus 1402 can receive the data carried in the infrared signal and place the data on bus 1402. Bus 1402 carries the data to main memory 1406, from which processor 1404 retrieves and executes the instructions. The instructions received by main memory 1406 may optionally be stored on storage device 1410 either before or after execution by processor 1404.

Computer system 1400 also preferably includes a communication interface 1418 coupled to bus 1402. Communication interface 1418 provides a two-way data communication coupling to a network link 1420 that is connected to a local network 1422. For example, communication interface 1418 may be an integrated services digital network (ISDN) card or a modem to provide a data communication connection to a corresponding type of telephone line. As another example, communication interface 1418 may be a local area network (LAN) card to provide a data communication connection to a compatible LAN. Wireless links may also be implemented. In any such implementation, communication interface 1418 sends and receives electrical, electromagnetic or optical signals that carry digital data streams representing various types of information.

Network link 1420 typically provides data communication through one or more networks to other data devices. For example, network link 1420 may provide a connection through local network 1422 to a host computer 1424 or to data equipment operated by an Internet Service Provider (ISP) 1426. ISP 1426 in turn provides data communication services through the worldwide packet data communication network, now commonly referred to as the "Internet" 1428. Local network 1422 and Internet 1428 both use electrical, electromagnetic or optical signals that carry digital data streams. The signals through the various networks and the signals on network link 1420 and through communication interface 1418, which carry the digital data to and from computer system 1400, are exemplary forms of carrier waves transporting the information.

Computer system 1400 may send messages and receive data, including program code, through the network(s), network link 1420, and communication interface 1418. In the Internet example, a server 1430 might transmit a requested code for an application program through Internet 1428, ISP 1426, local network 1422 and communication interface 1418. One such downloaded application may provide for one or more of the techniques described herein, for example. The received code may be executed by processor 1404 as it is received, and/or stored in storage device 1410, or other non-volatile storage for later execution. In this manner, computer system 1400 may obtain application code in the form of a carrier wave.

Further embodiments have been disclosed the following list of numbered clauses:
1. A method of controlling a broadband radiation source, the broadband radiation source comprising at least an optical fiber configured to receive pump radiation and generate broadband output radiation, the method comprising:
   obtaining ambient pressure data describing an ambient pressure in an environment of the broadband radiation source;
   controlling at least one parameter of the pump radiation in dependence of the ambient pressure data; and
   generating the broadband output radiation using the pump radiation to excite the optical fiber and/or a working medium confined therein.
2. A method as defined in clause 1, comprising measuring the ambient pressure to obtain the ambient pressure data.
3. A method as defined in clause 2, wherein the ambient pressure is measured at a location within or close to a pump radiation source for generating the pump radiation.
4. A method as defined in clause 1, comprising obtaining the ambient pressure data from a meteorological data source.
5. A method as defined in any preceding clause, wherein the at least one parameter of the pump radiation comprises a power metric and/or energy metric of the pump radiation.
6. A method as defined in clause 5, wherein the at least one parameter of the pump radiation comprises a peak power and/or peak energy of the pump radiation.
7. A method as defined in clause 5 or 6, comprising controlling the power metric and/or energy metric of the pump radiation via a modulation and/or attenuation of the pump radiation.
8. A method as defined in any preceding clause, wherein the at least one parameter of the pump radiation comprises a pulse shape metric of the pump radiation.
9. A method as defined in any preceding clause, wherein the at least one parameter of the pump radiation comprises a pulse width and/or chirp of the pump radiation.
10. A method as defined in any preceding clause, wherein the optical fiber comprises a hollow core fiber having a working medium confined within its core, and the generating step comprises generating the broadband output radiation using the pump radiation to excite the working medium.
11. A method as defined in clause 10, wherein the working medium and the hollow core fiber is sealed within a gas cell, such that the core of the hollow core fiber is in communication with, and the working fluid confined within, the gas cell.
12. A method as defined in any preceding clause, comprising low-pass filtering the ambient pressure data prior to using it for the controlling step.
13. A method as defined in any preceding clause, comprising averaging the ambient pressure data over time period on the scale of a minute or greater prior to using it for the controlling step.
14. A method as defined in any preceding clause, comprising referring to one or more of calibration data, a trained model and/or a calibrated relationship which relates the ambient pressure and the at least one parameter of the pump radiation, when performing the controlling step.
*15.* A method as defined in clause 14, comprising performing an initial calibration step to obtain the calibration data, train the trained model and/or calibrate the relationship between the ambient pressure and the at least one parameter of the pump radiation.
16. A method as defined in clause 15, wherein the calibration step determines an appropriate change in the at least one parameter of the pump radiation for a change in ambient pressure to obtain a desired broadband output radiation characteristic.
17. A method as defined in clause 15 or 16, wherein the calibration step comprises measuring the broadband output radiation for a varied at least one parameter of the pump radiation at a plurality of different ambient pressures.
18. A method as defined in any preceding clause, comprising measuring the broadband output radiation to obtain measured broadband output radiation data.
19. A method as defined in clause 18, comprising using the measured broadband output radiation data to determine an appropriate change in the at least one parameter of the pump radiation for a change in ambient pressure to obtain a desired broadband output radiation characteristic.
20. A method as defined in any preceding clause, comprising using the broadband output radiation to measure a structure formed on a substrate in a lithographic process.
21. A broadband radiation source comprising:
   a pump radiation source for generating pump radiation;
   an optical fiber configured to receive the pump radiation and generate broadband output radiation; and
   a control module operable to:
      obtain ambient pressure data describing an ambient pressure in an environment of the broadband radiation source; and
      control at least one parameter of the pump radiation in dependence of the ambient pressure data.
22. A broadband radiation source as defined in clause 1, comprising a pressure sensor operable to measure the ambient pressure to obtain the ambient pressure data.
23. A broadband radiation source as defined in clause 22, wherein the pressure sensor is located within or close to the pump radiation source.
24. A broadband radiation source as defined in clause 21, comprising obtaining the ambient pressure data from a meteorological data source.
25. A broadband radiation source as defined in any of clauses 21 to 24, wherein the at least one parameter of the pump radiation comprises a power metric and/or energy metric of the pump radiation.
26. A broadband radiation source as defined in clause 25, wherein the at least one parameter of the pump radiation comprises a peak power and/or peak energy of the pump radiation.
27. A broadband radiation source as defined in any of clauses 21 to 26, wherein the at least one parameter of the pump radiation comprises a pulse shape metric of the pump radiation.
28. A broadband radiation source as defined in any of clauses 21 to 27, wherein the at least one parameter of the pump radiation comprises a pulse width and/or chirp of the pump radiation.
29. A broadband radiation source as defined in any of clauses 25 to 28, comprising a modulator or attenuator for modulating or attenuating the pump radiation;
   wherein the control module is operable to control the power metric and/or energy metric of the pump radiation via the modulator or attenuator; and/or
   wherein the control module is operable to control the pulse shape metric of the pump radiation via the modulator or attenuator.
30. A broadband radiation source as defined in any of clauses 21 to 29, wherein the optical fiber comprises a hollow core fiber having a working medium confined within its core, the broadband radiation source being configured to generate the broadband output radiation by exciting the working medium confined within the core with the pump radiation.
31. A broadband radiation source as defined in clause 30, comprising a gas cell, wherein the working medium and the hollow core fiber is sealed within the gas cell, such that the core of the hollow core fiber is in communication with, and the working fluid confined within, the gas cell.
32. A broadband radiation source as defined in any of clauses 21 to 31, comprising a low-pass filter to low-pass filter the ambient pressure data prior to using it for the controlling step.
33. A broadband radiation source as defined in any of clauses 21 to 32, wherein the control module is operable to average the ambient pressure data over time period on the scale of a minute or greater prior to using it for controlling the at least one parameter of the pump radiation.
34. A broadband radiation source as defined in any of clauses 21 to 33, wherein the control module is operable to refer to one or more of calibration data, a trained model and/or a calibrated relationship which relates the ambient pressure and the at least one parameter of the pump radiation, when controlling the at least one parameter of the pump radiation.
35. A broadband radiation source as defined in clause 34, wherein the control module is operable to perform an initial calibration step to obtain the calibration data, train the trained model and/or calibrate the relationship between the ambient pressure and the at least one parameter of the pump radiation.
36. A broadband radiation source as defined in clause 35, wherein the control module is operable such that the calibration step determines an appropriate change in the at least one parameter of the pump radiation for a change in ambient pressure to obtain a desired broadband output radiation characteristic.
37. A broadband radiation source as defined in any of clauses 21 to 36, comprising an output detector for measuring the broadband output radiation to obtain measured broadband output radiation data.
38. A broadband radiation source as defined in clause 37, wherein the control module is operable to use the measured broadband output radiation data to determine an appropriate change in the at least one parameter of the pump radiation for a change in ambient pressure to obtain a desired broadband output radiation characteristic.
39. A metrology and/or inspection apparatus, comprising:
   a broadband radiation source as defined in any of clauses 21 to 38;
   wherein the metrology and/or inspection apparatus is operable to use broadband output radiation for performing a measurement.
40. A metrology and/ or inspection apparatus as defined in clause 39, configured as any one of: a scatterometer, a digital holography microscope, a level detector or an alignment sensor.
41. A lithographic apparatus comprising:
   an alignment sensor comprising the metrology and/or inspection apparatus of clause 40; and/or
   a level sensor comprising the metrology and/or inspection apparatus of clause 40.
42. A lithocell comprising:
   the lithographic apparatus of clause 41; and
   the metrology and/or inspection apparatus of clause 39 or clause 40 for measuring an exposed substrate subsequent to exposure on the lithographic apparatus.
43. A method of controlling a pump radiation source, the pump radiation source being configured to generate pump radiation for pumping a broadband radiation source to generate broadband output radiation, the method comprising:
   obtaining ambient pressure data describing an ambient pressure in an environment of the pump radiation source; and
   controlling at least one parameter of the pump radiation in dependence of the ambient pressure data.
44. A method as defined in clause 43, comprising measuring the ambient pressure to obtain the ambient pressure data.
45. A method as defined in clause 44, wherein the ambient pressure is measured at a location within or close to the pump radiation source.
46. A method as defined in clause 43, comprising obtaining the ambient pressure data from a meteorological data source.
47. A method as defined in any of clauses 43 to 46, wherein the at least one parameter of the pump radiation comprises a power metric and/or energy metric of the pump radiation.
48. A method as defined in clause 47, wherein the at least one parameter of the pump radiation comprises a peak power and/or peak energy of the pump radiation.
49. A method as defined in clause 47 or 48, comprising controlling the power metric and/or energy metric of the pump radiation via a modulation and/or attenuation of the pump radiation.
50. A method as defined in any of clauses 43 to 49, wherein the at least one parameter of the pump radiation comprises a pulse shape metric of the pump radiation.
51. A method as defined in any of clauses 43 to 50, wherein the at least one parameter of the pump radiation comprises a pulse width and/or chirp of the pump radiation.
52. A method as defined in any of clauses 43 to 51, comprising low-pass filtering the ambient pressure data prior to using it for the controlling step.
53. A method as defined in any of clauses 43 to 52, comprising averaging the ambient pressure data over time period on the scale of a minute or greater prior to using it for the controlling step.
54. A method as defined in any of clauses 43 to 53, comprising referring to one or more of calibration data, a trained model and/or a calibrated relationship which relates the ambient pressure and the at least one parameter of the pump radiation, when performing the controlling step.
55. A method as defined in clause 54, comprising performing an initial calibration step to obtain the calibration data, train the trained model and/or calibrate the relationship between the ambient pressure and the at least one parameter of the pump radiation.
56. A method as defined in clause 55, wherein the calibration step determines an appropriate change in the at least one parameter of the pump radiation for a change in ambient pressure to obtain a desired broadband output radiation characteristic.
57. A method as defined in clause 55 or 56, wherein the calibration step comprises measuring the broadband output radiation for a varied at least one parameter of the pump radiation at a plurality of different ambient pressures.
58. A computer program comprising computer readable instructions operable to cause a broadband radiation source to perform the method of any of clauses 1 to 20 and/or any of the clauses 43 to 57.
59. A computer program as defined in clause 58, wherein the radiation source comprises the radiation source of any of clauses 21 to 38.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical metrology, it will be appreciated that the invention, where the context allows, is not limited to optical metrology and may be used in other applications, for example optical lithography (e.g., as the illumination source for exposing a pattern on a reticle onto a substrate).

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A method of controlling a pump radiation source, the pump radiation source being configured to generate pump radiation for pumping a broadband radiation source to generate broadband output radiation, the method comprising:
obtaining ambient pressure data describing an ambient pressure in an environment of the pump radiation source; and
controlling at least one parameter of the pump radiation in dependence of the ambient pressure data.

2. A method as claimed in claim 1, comprising measuring the ambient pressure to obtain the ambient pressure data.

3. A method as claimed in claim 2, wherein the ambient pressure is measured at a location within or close to the pump radiation source.

4. A method as claimed in any of claims 1 to 3, wherein the at least one parameter of the pump radiation comprises a power metric and/or energy metric of the pump radiation.

5. A method as claimed in claim 4, wherein the at least one parameter of the pump radiation comprises a peak power and/or peak energy of the pump radiation.

6. A method as claimed in claim 4 or 5, comprising controlling the power metric and/or energy metric of the pump radiation via a modulation and/or attenuation of the pump radiation.

7. A method as claimed in any of claims 1 to 6, wherein the at least one parameter of the pump radiation comprises a pulse shape metric of the pump radiation.

8. A method as claimed in any of claims 1 to 7, wherein the at least one parameter of the pump radiation comprises a pulse width and/or chirp of the pump radiation.

9. A method as claimed in any of claims 1 to 8, comprising low-pass filtering the ambient pressure data prior to using it for the controlling step.

10. A method as claimed in any of claims 1 to 9, comprising averaging the ambient pressure data over time period on the scale of a minute or greater prior to using it for the controlling step.

11. A method as claimed in any of claims 1 to 10, comprising referring to one or more of calibration data, a trained model and/or a calibrated relationship which relates the ambient pressure and the at least one parameter of the pump radiation, when performing the controlling step.

12. A method as claimed in claim 11, comprising performing an initial calibration step to obtain the calibration data, train the trained model and/or calibrate the relationship between the ambient pressure and the at least one parameter of the pump radiation.

13. A method of controlling a broadband radiation source, the broadband radiation source comprising at least an optical fiber configured to receive pump radiation and generate broadband output radiation, the method comprising:
the method according to claim 1 to 12, and generating the broadband output radiation using the pump radiation to excite the optical fiber and/or a working medium confined therein.

14. A broadband radiation source comprising:
a pump radiation source for generating pump radiation;
an optical fiber configured to receive the pump radiation and generate broadband output radiation; and
a control module operable to:
obtain ambient pressure data describing an ambient pressure in an environment of the broadband radiation source; and
control at least one parameter of the pump radiation in dependence of the ambient pressure data.

15. A metrology and/or inspection apparatus, comprising:
a broadband radiation source as claimed in claim 14;
wherein the metrology and/or inspection apparatus is operable to use broadband output radiation for performing a measurement.
